# EUROPEAN PATENT SPECIFICATION

(11) **EP 2 364 525 B1**
(45) Date of publication and mention of the grant of the patent: **10.07.2013**
(21) Application number: 08741976.8
(22) Date of filing: 06.05.2008
(51) Int. Cl.: G06F 9/38, H03K 3/012, H03K 3/3562, H03K 19/096, H03K 3/356

(54) **SYNCHRONOUS SEQUENTIAL LOGIC DEVICE USING DOUBLE TRIGGERED FLIP-FLOPS AND METHOD FOR SKEWED TRIGGERING SUCH STATE STORING REGISTERS**
SYNCHRONE SEQUENTIELLE LOGIKVORRICHTUNG MIT DOPPELFLANKENGESTEUERTEN FLIP-FLOPS UND VERFAHREN ZUR ASYMMETRISCHEN LADUNG VON ZUSTANDSPEICHERNDEN REGISTERN
DISPOSITIF LOGIQUE SÉQUENTIEL SYNCHRONE UTILISANT DES BASCULES À DOUBLE DÉCLENCHEMENT ET PROCÉDÉS DE DÉCLENCHEMENT DÉSALIGNÉ DE CES REGISTRES DE STOCKAGE D'ÉTAT

(43) Date of publication of application: 14.09.2011
(73) Proprietor: Laboratory For Microelectronics (LMFE), 1000 Ljubljana (SI)
(72) Inventor: RAIC, Dusan, 1000 Ljubljana (SI)
(86) International application number: PCT/SI2008/000027
(87) International publication number: WO 2009/136875

(56) References cited:
- US-A1- 2006 061 400
- US-A1- 2006 104 124
- US-A1- 2008 074 151

## Description

The presented invention belongs to the technical domain of electronics, especially to details of semiconductor circuitries for integrated digital signal or mixed signal logic devices. It is a new approach for the construction or re-synthesis of digital design blocks by introducing the systematic usage of double triggered Flip-flops in combination with a suitable clock tree design using transit time feedback. The new configured devices allow improved performance due to reduction of peak supply current, reduction of power supply consumption and reduction of the noise-influence that causes in worst case corruption and malfunction or especially on analog design-parts a reduction in quality.

### PRIOR ART - STATE OF THE ART

Traditional designs for state machines or sequential logic controls use edge triggered flip-flops. These registers keep the output state stable till the triggering edge allows updating the output value with the content of the value at a data input. The data input shall be constant a certain time before the trigger (setup-time), and sometimes a certain time after the trigger (hold-time) to achieve reliable functionality. The main approaches for a synchronous machine are defined by Mealy and Moore. The Mealy machine is a finite state machine. It generates a new output state due to the combination of an actual state, given by a number of registers and input signals at a signal edge. The Moore machine generates a new output state of an existing state without external input signal controls.

Most digital electronic systems are designed as clocked sequential systems. These systems are a restricted form of Moore machine where the state changes only when the global clock signal changes. Typically the current state is stored in flip-flops, and a global clock signal is connected to the "clock" input of the flip-flops. A typical electronic Moore machine includes a combinatorial logic chain to decode the current state into the outputs.

A variety of integrated edge triggered flip-flops are used in current sequential logic designs. "Digital System Clocking: High-performance and Low-power Aspects" of Vojin G. Oklobdzija edited by Wiley & Sons ISBN-10: 047127447X gives a detailed overview of the given state of the art. Most designs are using double latch constructions for each register bit. These master-slave configurations result in fast reliable operation at a low need of silicon area.

"Analysis and Design of Low-Energy Flip-Flops" by Markovic, D.; Nikolic, B.; Brodersen, R.W. in Low Power Electronics and Design, International Symposium on, 2001. Volume , Issue , 2001 Page(s):52 - 55 ISBN: 1-58113-371-5, describes the most used typical designs of master-slave latch pairs, like Transmission-gate based master-slave flip-flops, modified C²MOS master-slave (MS) flip-flops, the Power PC603 combination of the former two, or the NAND-NOR MS flip-flops.

A younger publication is "An Efficient Implementation of D-Flip-Flop Using the GDI-Technique" by Arkadiyi Morgensthtein, a paper out of: ISCAS '04, Proceedings of the 2004 International Symposium on Circuits and Systems 2004. Publication Date: 23-26 May 2004 Volume: 2, On page(s): II- 673-6 Vol.2, ISBN: 0-7803-8251-X. In this article Gate-Diffusion-Input (GDI-) technology based flip-flops are compared to other flip-flop technologies.

US 6,459,313 B1 describes a IO Power Management Synchronously Regulated Output Skew, wherein a number of n outputs are buffered at a first parallel clock edge and in a second step by further n D-flip-flops with sequentially shifted clock trigger-signals forwarded to the output pads.

A FIFO is a known register that puts out data after shifting it through a register chain. First data bit that comes in will go out first (First-In-First-Out). A two bit FIFO, transfers the data from the input in two steps, two clock cycles transfer the input data to the output.

Double latch based flip-flops used in synchronous design do not allow significant clock skew. The clock path delay depends on the combinational logic path delay.

### TASK OF THE INVENTION

Based on this existing technology a new design technique for synchronous sequential circuits was looked for to achieve better performance in terms of less power consumption, less noise production, lower peak supply current requirements and thus less distortion or impact to analog design parts. The new design methodology shall allow re-synthesizing existing digital designs with minimal effort, existing tools should stay usable. The required design area shall be comparable to the traditional designed blocks. Therefore automatically routing and placing shall be possible without big variation of the tools; the generation of a net list should be as simple as before. The new sequential synchronous design shall result in an optimal usage of the repeated synchronous time-frames defined by two edges of the system-clock. The energy for switching shall be de-concentrated by synchronously skewing. The disadvantages of the co-incidence for a parallel data transfer from all the input of the used flip-flops to there output shall be removed. The invention should allow separating the point-in-time of acceptance of data at a flip-flop from the points in time of release of data to the logic for preparing the next state. This leads to a systematic usage of double triggered flip-flops. These flip-flops need to be differentiated from those which transfer data from the Input to the Output at both edges as this is the case at Double- or Dual edge triggered flip-flops. Double triggered flip-flops in this context are state storing flip-flops that need two edges, one for the input storage and one for the storage content release to the output.

### SUMMARY OF THE INVENTION

The tasks of the invention are solved by the invention characterized in the presented claims.

Proposed is a synchronous sequential logic device with a combinational circuit to sequentially combine the output values of state storing registers and input data and to feedback the actual status to derive subsequent logical states and controlling or indicating outputs like in counters, sequential control systems or state machines. The invented device requires a plurality of flip-flops that are triggered two times during each clock cycle. This is performed in a way that each flip-flop has different points in time for the acceptance of a new data value at its data input and for the release of the data value at its data output. Between these points a frozen content state is kept invisibly at the ports of the flip-flops.

The points in time are defined by different edges at two separate clock inputs, preferably by consecutively edges of one single clock signal at both clock inputs. Therefore different edges of one clock signal (or two clock signals) are used to shift the signal in two steps through each flip-flop. This is functionally comparable to a 1 bit FIFO with two serial connected edge triggered flip-flops.

The used flip-flop of the invention could be designed to accept data at the data input at the positive edge of a signal at and release the content value at the negative edge of a signal, which would be a first type. The corresponding clock signals may be one or two. The data input and data outputs are similar to conventional registers.

Conversely another type of the invented flip-flop is designed to accept data at the negative edge of a signal and releases the data at the positive edge.

For completion, a third type of state storing registers is considered to be useful, that accepts data at both edges of a signal at the first clock input and releases the buffered content at the subsequent positive or negative edge at the second clock input.

Advantageous is a second data input for scan purpose in design-for-test requirements. An input selector especially a multiplexer is required to disconnect the combinational logic from the registers and reconnect to the test-signal-path.

The third type of a state storing flip-flop may be built by a parallel combination of a flip-flop of the first type and a modified flip-flop of the second type whereby the data inputs, the data accepting clock-inputs and the content releasing clock-inputs are connected together. The output of this third type could be the multiplexed outputs of the used flip-flops using the content clocking signal for the selection.

Instead of combining two serial edge triggered flip-flops to derive the state storing registers, it is advantageous to take a combination of three serial latches. Also a master-slave flip-flop and a latch may allow the same result. The new configuration is representing two stages of master-slave configuration, preferably denominated "master-slave-subslave" configuration.

A lot of latches are usable. The most interesting technologies are represented by mC²MOS-, PowerPC-, Transmission-Gate-based, NAND-NOR-gate based, Gate-Diffusion-Input technology based or Differential Amplifier based configurations, all known in master-slave configurations. In detail:

Using sub-micron technology e.g. 0.18µm CMOS semiconductor process technology, it is advantageous to use modified clocked complementary metal oxide semiconductor circuits mC²MOS for at least one of the three latches. In this latch a clocked CMOS inverter and a feedback loop with a CMOS inverter and either a further clocked CMOS inverter or a transmission gate are combined.

Alternatively at least one latch is constructed in an extended PowerPC-latch-configuration given by, and a feedback loop with an inverter and a clocked inverter. Also possible is the usage of an extended Transmission-Gate based latch build of a clocked transmission gate and a loop of an inverter and a second clocked transmission gate.

A further combination of latches may be resulting in a state storing flip-flop, when the master and the sub-slave are AND-NOR-latches and the slave is an OR-NAND-latch. Otherwise the master and the sub-slave could be OR-NAND-latches and the slave an AND-NOR-latch.

A further advantageous construction of the flip-flops may be constructed in Gate-Diffusion-Input-technique, wherein each latch comprises two gate clocked pmos - nmos serial circuits connected to two complementary data inputs and two inverters for inverting the outputs of the pmos devices to the third connection of the nmos devices of the - in each case other branch.

Another possible solution is represented by a clocked sense amplifier stage with differential inputs and differential outputs for the three latches.

A lot of different solutions are possible, normally the used techniques are the same, but it might be useful to combine three latches of at least two different types to a flip-flop having two separated edge trigger points in time for acceptance of the input-data and release of the internal stored value to the output.

Beside separating the time in point for acceptance of that for release of data values at a number of n modified flip-flops of first, second or third type (1,2,3), also these clocks at different flip-flops advantageously shall be serially clocked in time. Normally this skewing is generated by serially connecting inverter chains to build a clock tree branch. This anticoincidence allows reducing extreme values of charging currents for parasitic capacitances and distortions through noise. The clock signals are spread.

Instead of directly using a system clock signal, a pulse generator may be used which is triggered by the rising or falling edge of this clock signal to drive all clock inputs of the flip-flops. The pulse generator generates skewed first edge signals for the acceptance points in time - along all n modified flip-flops. The last signal change of these subsequently generated trigger signals, asynchronously terminates the pulse duration by a reset to generate a skewed second edge signal for the release points in time in the same order along all n modified flip-flops.

In order to use both edges of the system clock for the control sequential logic block, two pulse generators and two branches of modified flip-flops may be designed. In this case one pulse generator is triggered by the rising edge and the other is triggered at the falling edge of a system clock.

Instead of one branch also two or more parallel branches might be designed with the same or a different number of modified flip-flops. The slowest clock transit through the branches determines the termination of the generated pulse-sequence.

The invention further comprises a method for triggering a plurality of state storing registers within a sequential synchronous logic device using above mentioned state storing register types that have separated controlling means for acceptance and release of data.

At first, a first edge of a clock pulse synchronous to the system clock is generated. This is sequentially shifted in time with skew producing devices to spread the points in time for acquisition of input data from an interface or a combinational circuit among the clock inputs for acceptance of the special double edge triggered registers. Secondly, using the last edge of the first sequentially time shifted edges to finalize the duration of the clock pulse and to generate a second edge. This is sequentially in time with skew producing devices to spread the points in time among the clock inputs for release of the previously stored input data values of each register at their outputs.

Preferably the first and the second edge are the transitions of the logical states of a single signal whose state is either changed by the system clock or the last transition point in time of the shifted edges and wherein the separated controlling means are clocked by this single signal respectively its retarded derivatives.

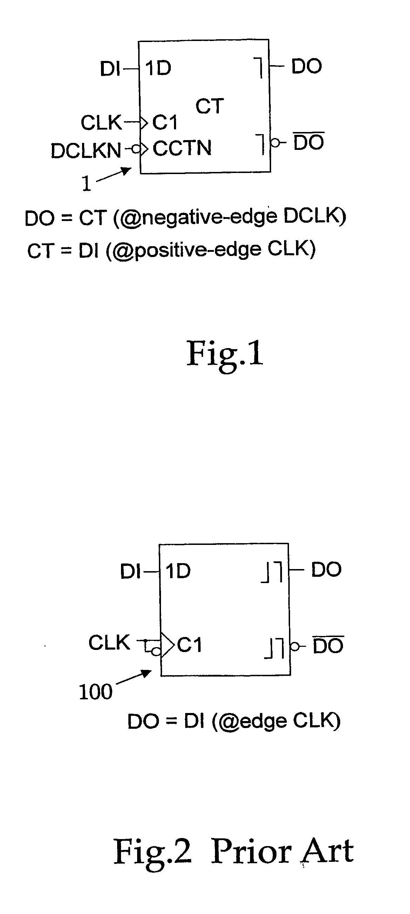

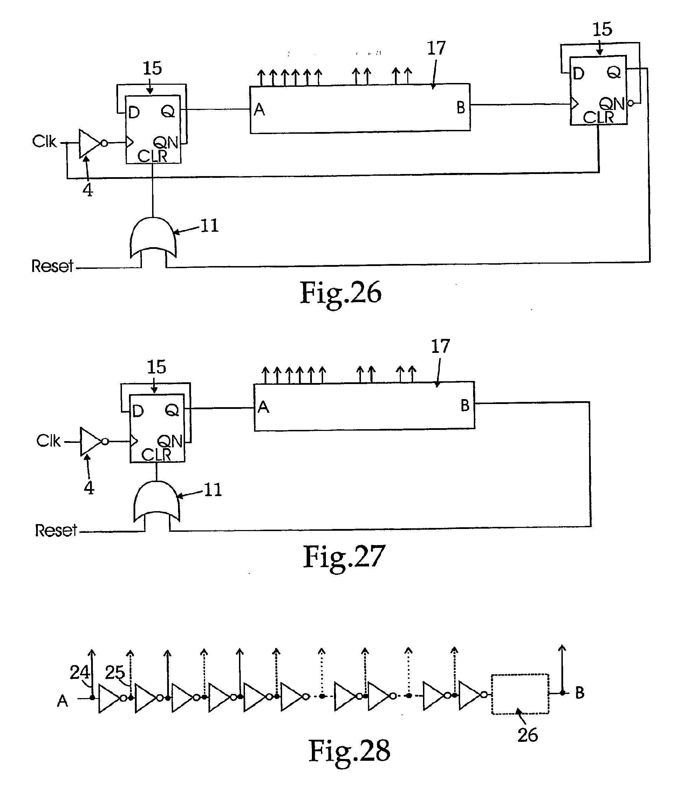

The innovation is detailed described in following embodiments:
**Fig.**1 shows the symbol for a separate Input-Output controlling edge-triggered buffer flip-flop of a first type **1** for usage within the invention.
**Fig.**2 is a prior art device symbol of a dual-edge or double-edge triggered flip-flop **100,** with different functionality compared to the device represented in **Fig.**1
**Fig.**3 is the symbol of an alternatively usable second type **2** of a separate Input-Output controlling edge-triggered buffer flip-flop for usage within the invention, wherein the edges of the triggering inputs are in opposite direction compared to the corresponding trigger inputs of the device represented in **Fig.**1.
**Fig.**4 is a device level schematic of a variation of the device of **Fig.**2 with separated trigger signals for input-acceptance and output-release usable as a third type **3** within the invention.
**Fig**.5 is the symbol of a separated Input-Output controlling dual-edge triggered buffer flip-flop type **3.**
**Fig.**6 and **Fig.**7 indicate the typical single signal connection of the first and second type **1,2** of a modified flip-flop used within the invention to a clock tree signal CLK or a trigger pulse.
**Fig.**8 shows the typical single signal connection of a third type **3** device of a modified flip-flop used within the invention to a clock tree signal CLK or a trigger pulse.
**Fig.**9**, Fig**.11 and **Fig.**13 show a combination of the devices of type **1,2** or **3** with transition time consuming elements **40** to increase the delay between input acceptance and output release, for the case where only one triggering signal CLK is used.
**Fig.**10, **Fig.12** and **Fig**.**14** show a combination of the devices of type **1,2** or **3** with transition time consuming elements **40** to decrease the delay between input acceptance and output release for the case where only one triggering signal CLK is used.
**Fig.**15 and **Fig.**16 are prior art schemata of D-flip-flops (master-slave) in mC²MOS (modified Clocked Complementary Metal Oxide Semiconductor) technique, with transistor level clocked inverters **5** and gate level inverters **4.**
**Fig.**15a is a transistor level schematic of the prior art inverter **4** used in Fig.15ff.
**Fig.**17 shows the schematic and **Fig.**17a the modified device symbol **22** of a possible embodiment of a separate Input-Output controlling edge-triggered buffer flip-flop of a first type **1** for usage within the invention using mC²MOS technique and using the same signal but different edges for the input data acceptance and output data release.
**Fig.**18 shows the device given by the schematic in **Fig**.17 but with separated trigger signal inputs.
**Fig.**19 shows a modified embodiment of **Fig.**17with scan input for testability.
**Fig**.19a is the proposed symbol **27** for the schematic of **Fig.**19.
**Fig.**20 is a schematic of a transmission gate latch based master-slave-subslave flip-flop (TGMSS).
**Fig.**21 is a gate level schematic of NAND-OR/NOR-AND buffer flip-flop (master-slave-subslave) with separated trigger inputs for data acceptance and data release with the symbol of **Fig.**3.

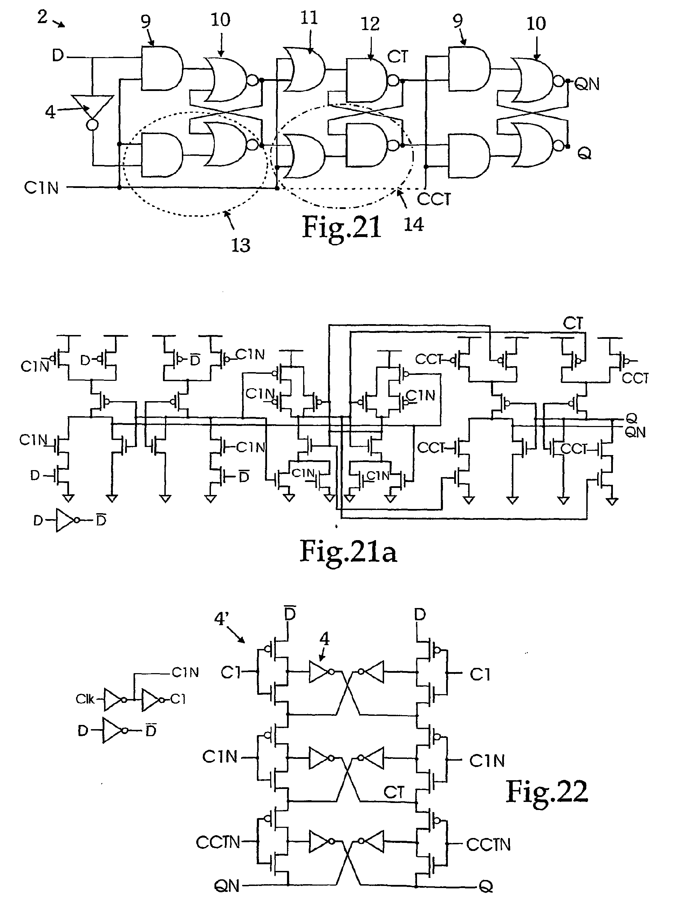

**Fig.**21 a is the transistor level embodiment of the flip-flop in **Fig.**21.
**Fig**.22 is a further example of a buffer flip-flop given by the symbol of the first flip-flop type 1 in **Fig.**1 using Gate-Diffusion-Input technique.

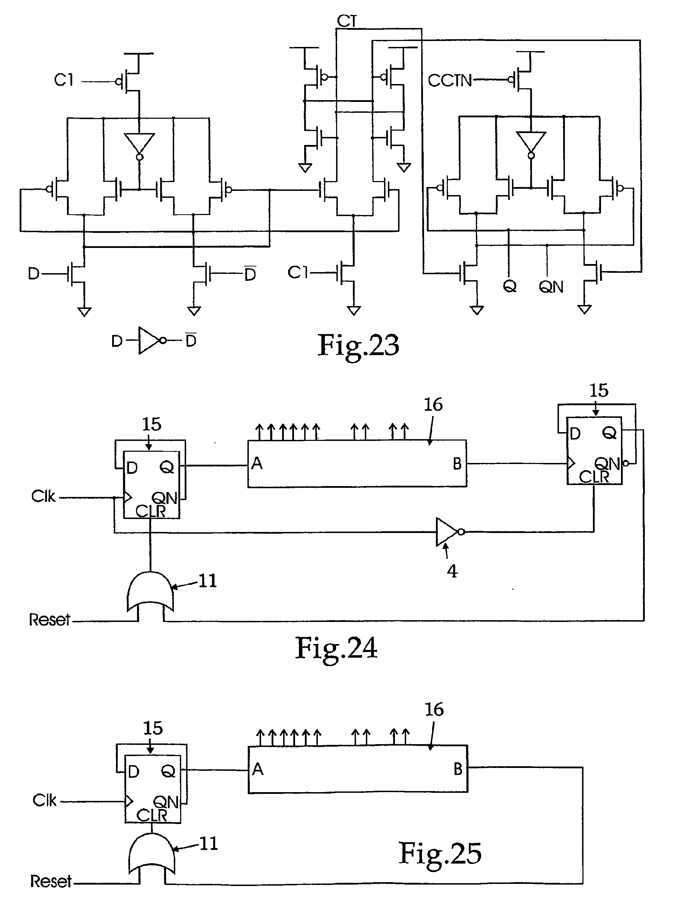

**Fig.**23 is a schematic of a flip-flop using three differential sense amplifiers in Static Single Transistor Clocked architecture (SSTC) with a functionality of a typical flip-flop of the first type 1 given by the symbol in **Fig.**1.
**Fig**.24 and **Fig.** 25 are embodiments of pulse generators to sequentially clock the separate Input-Output controlling edge-triggered buffer flip-flops of types **1,2, or 3** for the positive edge of the master clock Clk. **Fig**.26 and **Fig.**27 are the corresponding embodiments triggered by the negative edge of the master clock Clk. **Fig**.25 and **Fig**.27 require a maximum skew-delay of less than one master clock cycle, while **Fig.**24 and **Fig.**26 require a maximum skew-delay of less than the leading phase duration of the master clock.
**Fig.**28 is the skew generating block to spread the clocking points in time of the registers.

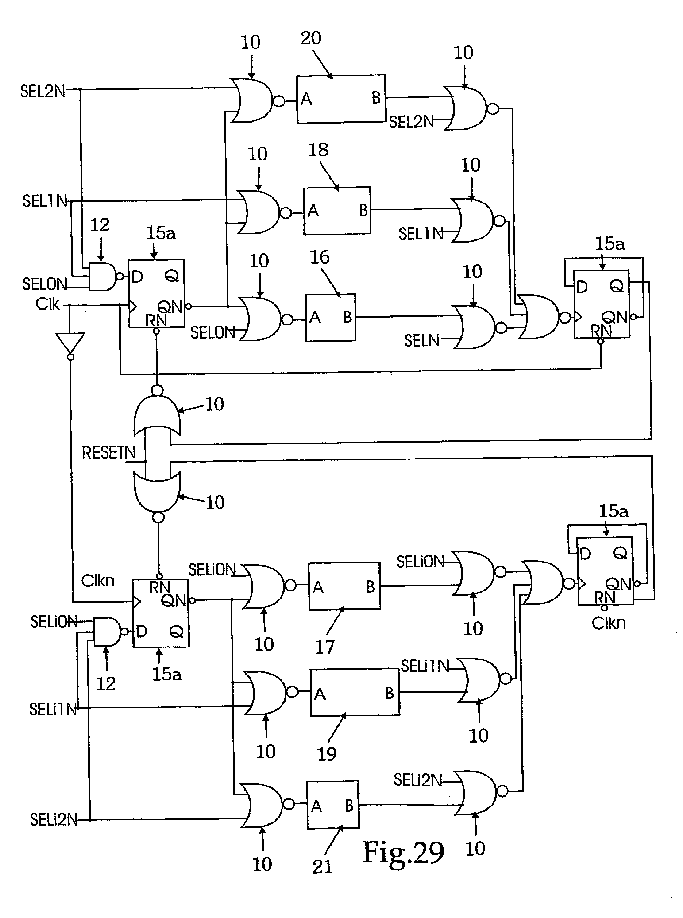

**Fig.**29 is a spread clock system implementation example using three parallel branches for both edges of the master clock Clk in using NAND and NOR gates and D-flip-flops with logic low reset inputs.

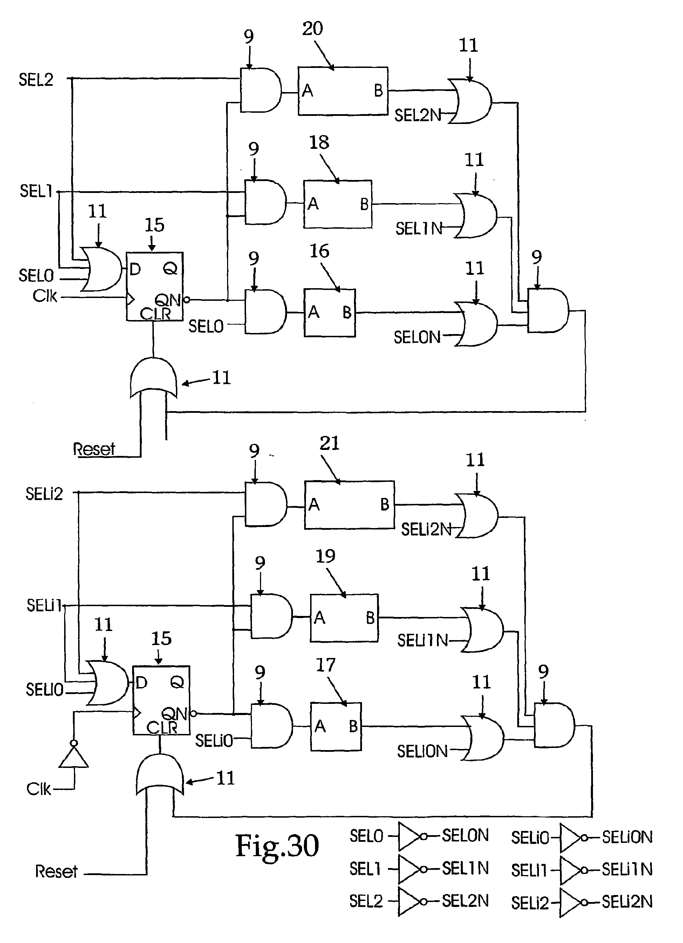

**Fig.**30 is an alternative spread clock system implementation compared to **Fig.**29 example using AND and OR gates and D-flip-flops with logic high clear inputs.

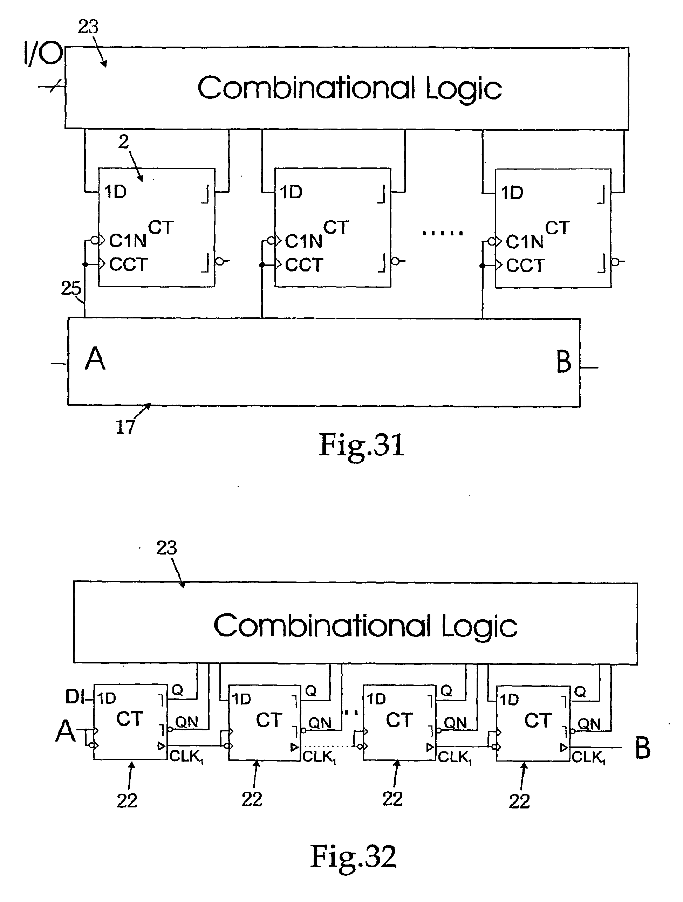

**Fig.**31 shows the typical connection of the skew generating block **17** to a number of separate Input-Output controlling edge-triggered buffer flip-flops (here: of the second type **2)** and the typical connection of these to the Combinational Logic Block **23** at a typical synchronous device in compliance with the invention.
**Fig.**32 is an example wherein the skew generating block is built with the internal elements of the flip-flop-structure compared to flip-flop **22.**

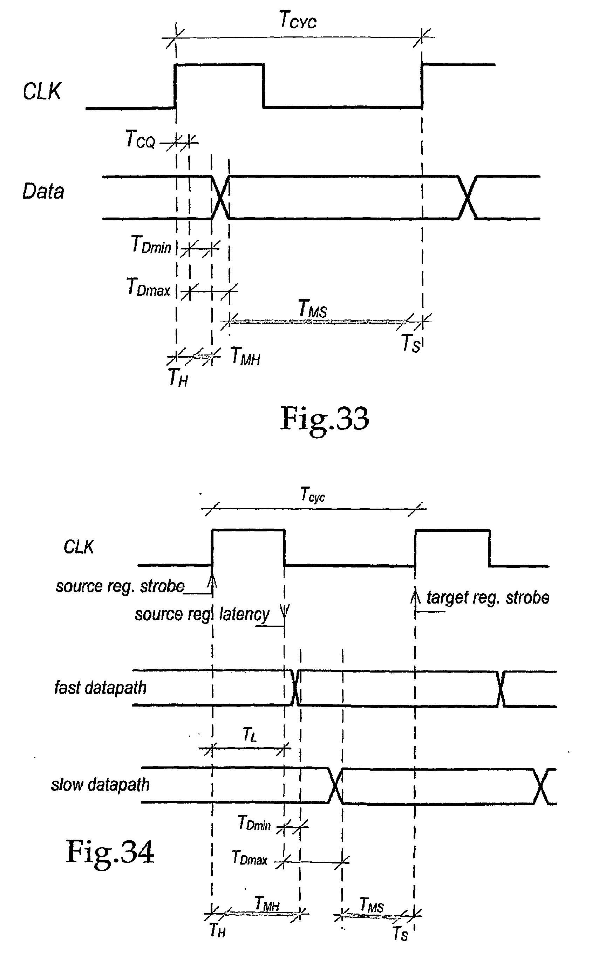

**Fig.**33 is the timing diagram of traditional registers (Master-Slave flip-flop).
**Fig.**34 is the timing diagram of the double triggered register (Master-Slave-Subslave).

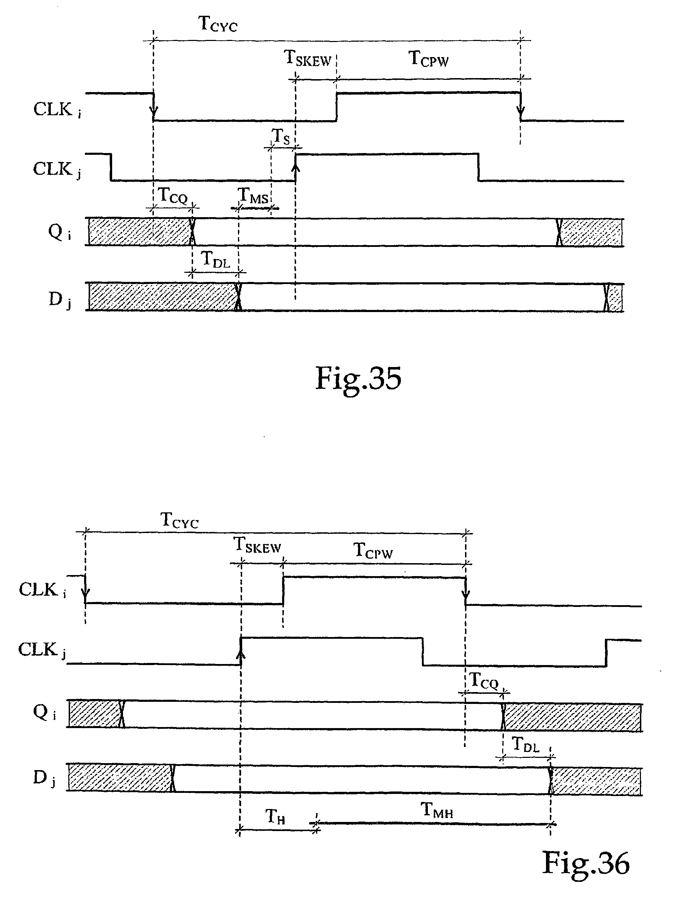

**Fig.**35 and **Fig.**36 are the timing diagrams of two subsequent logically connected flip-flops **1** with single clock trigger and introduced skew.

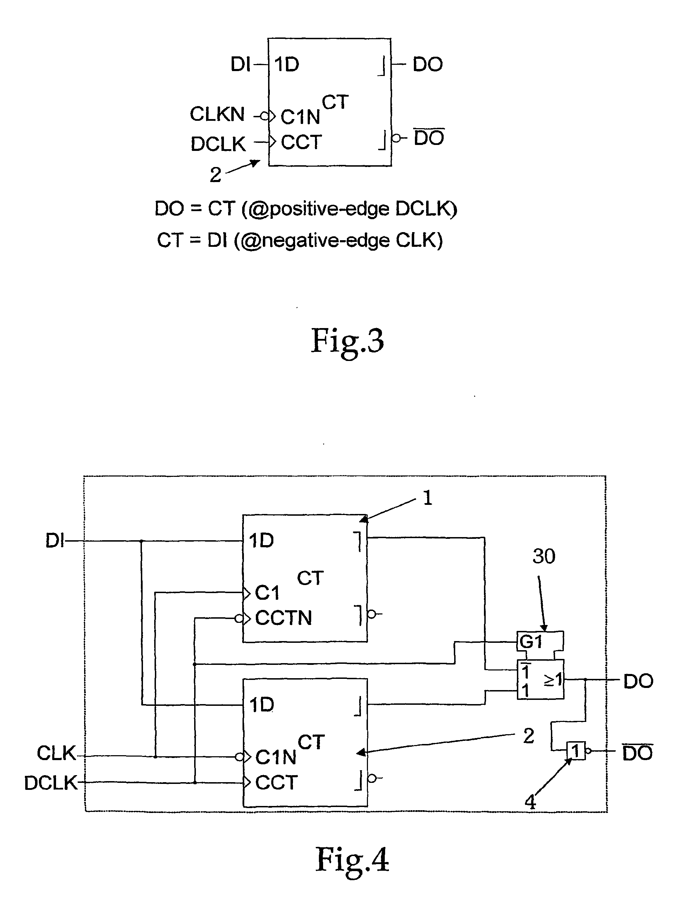

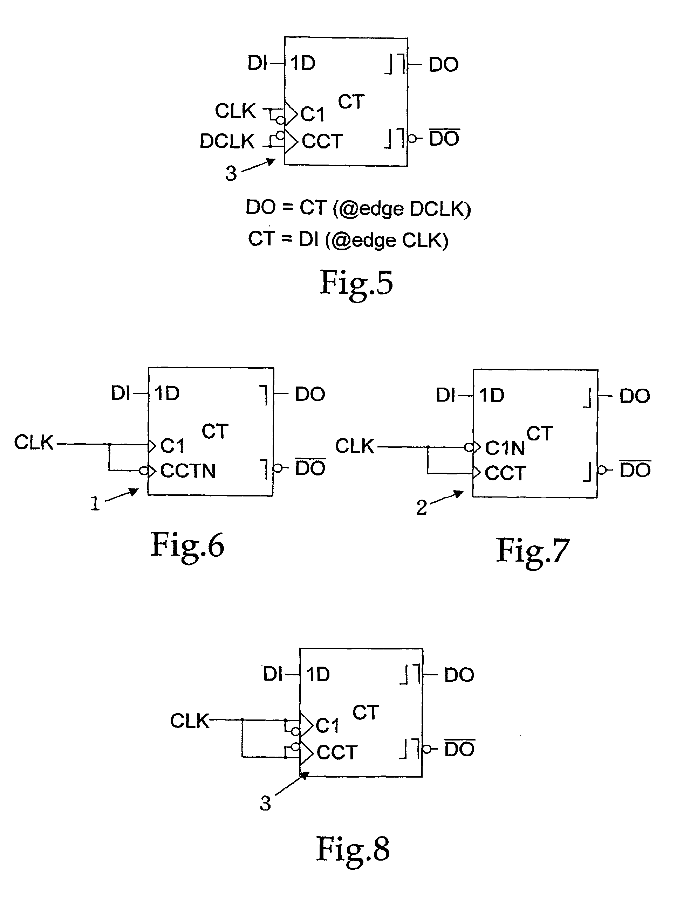

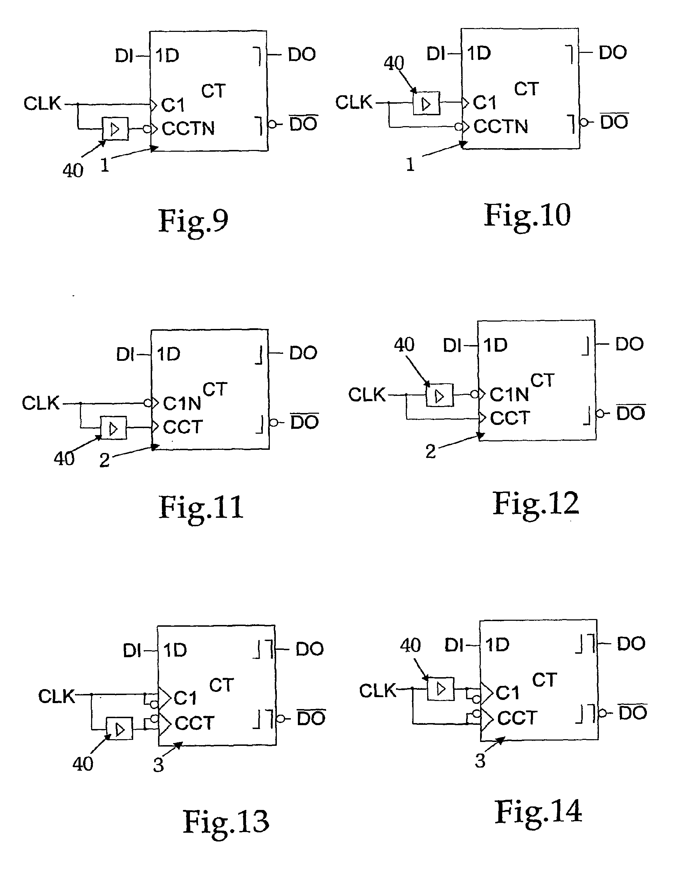

Using the devices whose symbols **1,2** are shown in **Fig**.1 and Fig.3-14 allow to separate the point in time for storing or fixing a data input value DI from the points in time of the release from internal to the output DO. Either two clock signals CLK, DCLKN or CLKN, DCLK could be used to generate the trigger points as shown in **Fig**.1 and Fig.3-5 or only one signal may be used. If only one signal is used, the clock signals leading edge is controlling the input acceptance and each subsequently following active edge is controlling the release of the content to the output DO and optional to the inverted output. In the examples of **Fig**. 1,3,6,7 and **Fig**.9-12, one clock input has a rising edge as the active edge, while the other clock input has a falling edge as the active edge. This allows directly connecting the two clock inputs, resulting in the case, that each odd clock edge at the shorted inputs triggers the acceptance of input data and each even clock edge triggers the release of this stored data to the output, starting with the active edge of the input clock trigger C1 or C1N, see **Fig**.6 and **Fig.**7. The delay is given by the duration of the high respectively the low clock-phase. This delay might be changed with retarding elements **40** to additionally or correctively add or reduce the time distance between the trigger points in time, see **Fig**.9 to **Fig.**12.

An already known element is symbolized in **Fig.**2, which is a dual or double edge triggered flip-flop, shifting the input data DI at the input 1 D at each edge of the clock signal CLK to the output DO without buffering internally.

A double edge - double triggered flip-flop may be constructed out of two double edge triggered flip-flops **1,2** with inverted clock inputs and a multiplexer **30.** This is shown in **Fig.**4 with the representing symbol **3** in **Fig.**5. In this case the falling and the rising edges are active. The first edge controls the data acceptance the subsequent edge at the second clock input the data release. The dealing of only one signal on both clock inputs coincidentally or skewed is also possible, **Fig.**8, 13, 14. This method doubles the state changing rate at a given system clock. For the presented invention the third type is of less interest as the modifications need deeper system analysis. In special cases the third type might allow faster algorithms. For example, if the logic combinational block is doubled and the input and output signals are multiplexed too.

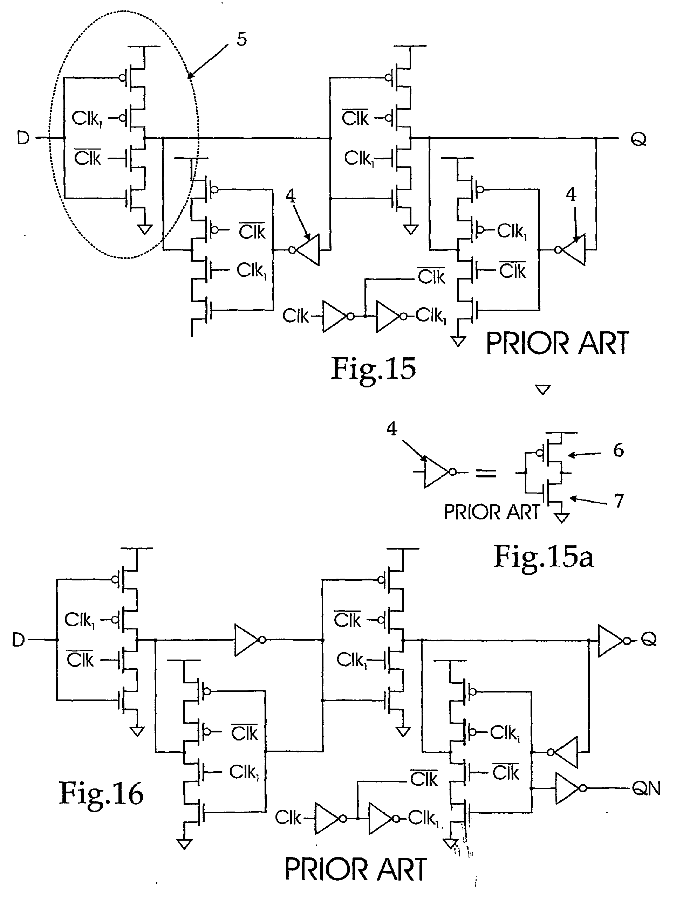

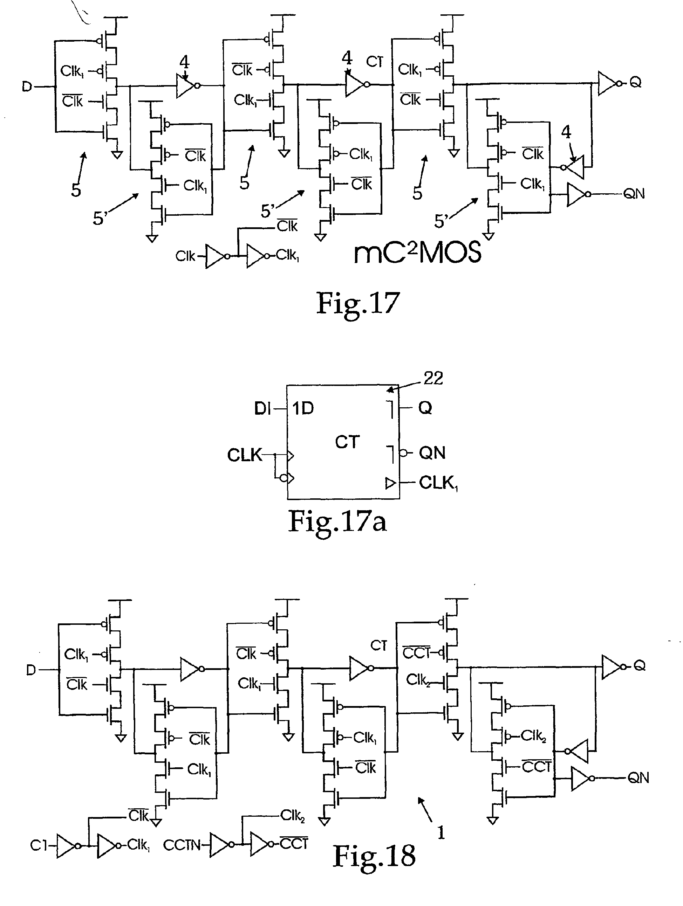

To construct the required flip-flop of a first type with the same clock signals, a smart way would be changing the typical double latch construction, as shown in **Fig**.15 and **Fig.**16 - which is a flip-flop in modified clocked CMOS technology mC²MOS - into a triple latch construction, **Fig.**17. This construction uses clocked inverters **5** and inverters **4** in CMOS-technology (complementary metal oxide semiconductor) made of pmos-transistors **6** and nmos-transistors 7. The symbol **22** in **Fig.**17a also shows the additional usable delayed output CLK₁.

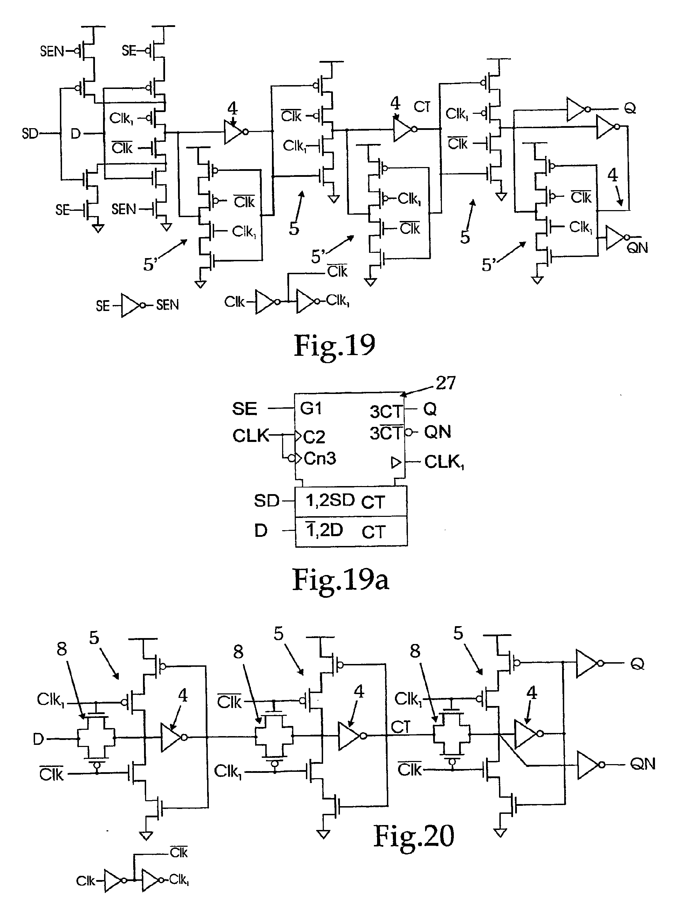

Using separate clock signals as shown in **Fig.**18 further inverters are required. As an industrial standard additional scan input and scan enable is often mandatory for sufficient and fast testability, the modification might be done according to **Fig.**19 with a symbol like in **Fig.**19a**.** Although the mC²MOS is preferred for new designs especially in 0.18µm CMOS-process technology, other solutions are not excluded of this invention. **Fig.**20-23 show further solutions (here shown without scan input and input selector, which is also possible).
A transmission gate **8** latch based master-slave-subslave flip-flop or triple latch, especially in a powerPC configuration combined with mC²MOS is an alternative solution, **Fig.**20. NANDNOR-technology **Fig.**21, **Fig.**21 a could be modified by using three subsequent NAND-OR/NOR-AND latches with inverted data inputs and outputs (master-slave-subslave). The two ANDNOR gates **13** are combined to one first latch and two further ANDNOR gates are combined to the last (third) latch. The middle latch is designed by two ORNAND gates **14.** The control input of the third latch CCT is a second separated trigger input.
Using Gate-Diffusion-Input technique enables in an interesting triple latch configuration as shown in **Fig**.22. The complementary Data inputs are connected to the Source contacts of the pmos transistors the complementary Data outputs are given at the Source contacts of the linked nmos transitors. The gates are clocked, at each latch with inverted clock signal.
Last but not least sense amplifier stages with feedback loop may be combined to a triple latch configuration as shown in **Fig.**23.

Two representative arrangements for the invention are shown in **Fig.**31 and **Fig.**32. These show synchronous sequential logic device blocks using above described double triggered flip-flops. In **Fig.**31 a number of n flip-flops **2** of the second type are sequentially triggered with skewed clock signals. The skewing is performed by block **17,** which represents a time shifting block due to transmit-delays of logical elements. The different clock inputs of the flip-flops 2 are shorted. Therefore the negative spread edges trigger the data saving into the internal content memories CT. The data inputs are the logically combined values of selected registers due to the requirements of the state machine. The positive spread edges release these data to the outputs of the flip-flops and allow their combination for a new state.

A possible configuration of the skewing block is shown in **Fig.**28. The delay of the clock signal is caused by the transfer through two serial connected inverter gates. n distributed clock lines require 2n inverters. The optional additional time delay block **26** could be used for adjusting the pulse-generation method as shown in **Fig.**24-27**,** and **Fig.**29, described below.

**Fig.**32 indicates that a skewing block **17** might be implicitly caused by the flip-flop chain here: constructed by flip-flops **22** of a first type with clock-forwarding. In this case the rising edge loads the memory with the logic contents and the falling edge releases the data for recombination by the combinational logic.

The clock input A might be connected directly to the system clock. The phase before the loading edge of each flip-flop **22** (**Fig**.32), or **2** (**Fig.**31) must be long enough for settling all combinational processes of the last output triggered state for the considered flip-flop. But the signal also must be stable within a minimal setup time before the clock transition for loading the data value into the content memory. The margins of the setup-time and the hold-time are depending on the period of the system clock T_{Cyc}. The maximal delay of the worst case under worst conditions (caused by temperature, tolerances in process-parameters) could be represented in the path with the maximum skew of the clock-tree plus the clock-to-output valid delay of the last triggered flip-flop added by the delay of the corresponding combinational logic for each flip-flop's input and the minimal required setup time at the data input of the first triggered flip-flop. The phase between output release and new loading must be at least this maximal delay. The larger the distance between the releasing edge and the subsequent devices loading edge, the larger is the setup-time margin.

Further the input signal at each flip-flop need to be stable at least for the hold time after the loading clock signal edge. If e.g. the input data of the last clocked flip-flop in Fig.31 already changes within the hold time due to a new output release trigger edge at the first flip-flop the content CT of this register might be corrupted.

Compared to traditional sequential synchronous designs the advantages is obviously given by the higher design flexibility as the state modifications of a register bank is separated into two steps by either two synchronous (time shifted) clock signals using one or both edges, or one alternating clock signal using different clock edges for different purposes. Instead of data evaluation and transfer to a new modification with the same edge the processes are detached.

Using a system clock edge triggered pulse-generators to drive the skewing block the maximal clock delay might be used to derive the release trigger points after the last acceptance trigger point in time. **Fig**.24 to **Fig**.27 show typical embodiments of such types of pulse generators. **Fig.**26 and **Fig.27** are triggered by the negative edge of the system Clock Clk, while **Fig.**24 and **Fig.**25 use the positive edge. Also a dual edge triggered solution is possible. These circuits use traditional D-flip-flops **15** (master-slave) with asynchronous Clear in an alternating state configuration. After the global initial reset, the input of the skewing block A, is preset to zero. The rising edge produced by output Q of the flip-flop, at the Clocks Clk active edge, by passing the value at QN to Q. The sequence of first edges for data acceptance at the double triggered flip-flops is started. The output value at B of the skewing block 16 is the maximal delayed value of A. This delayed value either clears the clock generating flip-flop asynchronously to start the release-edges sequence (of the same duration). If the clock cycle period is lower than these two cycles the next active edge would invert the output synchronously (**Fig**.25, **Fig**.27).

In **Fig**.24 and **Fig**.26 a second toggle flip-flop is used to generate asynchronously the second edge for the release-edges sequence before the system clock state change or to force the releasing phase synchronous to the second clock phase.

As a typical embodiment for multi-branched clock tree installation using pulse generators is shown in **Fig.**29. Different structured skew-blocks **16-21** (with different delays and number of driven flip-flops) using opposite triggers Clk, Clkn edges for register-branches in different system blocks are shown. This example uses NOR and NAND gates by inverted logic. The skewed signals are connected to typical registers of type **1** or **2.**

The separate Input-Output controlling edge-triggered buffer flip-flop allows the sharing of the global clock period between the setup and hold time intervals. It also allows the logic control over the sharing of these two intervals. With double triggered registers, any clock distribution architecture can be safe provided that the global clock cycle time is large enough to satisfy the setup time margins and that adequate sharing of data setup and hold times is assured either by the global clock waveform or by logic control over local clock signals.

It is advantageous to combine double triggered registers with traditional registers to further save switching energy. The major role of the triple latch registers in combined circuits is to assure positive hold time margins in local data paths where clock skew would imply negative hold time margins if traditional registers were used. Comparing **Fig.**33 that shows a simple D-flip-flop (master-slave) timing with **Fig.**34 the improvement for the hold time margin T_{MH} is figured out. The hold time margin in the new concept is T_{MH}=T_{L}+T_{Dmin}, wherein T_{L} is the latency given by the time between the edge for data acceptance and the edge for data release and T_{Dmin} is the minimal time delay caused by the combinatorial logic for next registers. This time may be regulated by the duty cycle of the Clock Signal CLK. At existing systems the hold time margin is T_{MH}=T_{CQmin}+T_{Dmin}-T_{H}, with the Clock to Output delay time T_{CQmin} and the hold time T_{H}.

It is obvious that the T_{MH} in traditional circuits is very small compared to the setup time margin T_{MS} which is nearly one clock cycle T_{Cyc}: T_{MS}=T_{Cyc}-T_{S}-T_{CQmax}-T_{Dmax}, with the setup time T_{S}, the maximal clock to data out delay T_{CQmax} and the max. combinational delay T_{Dmax}.(**Fig**.33).

In the new design, the hold time margin and the setup time margin are based on the duty cycle and typically of the same size, if T_{L}=T_{cyc}/2. The setup time margin is reduced by the latency: T_{MS}=T_{Cyc}-T_{L}-T_{DMax}. **(****Fig.**34**).**

Using two registers and introducing skew, the typical timing diagrams of the new concept are shown in **Fig.**35 and **Fig.**36. **Fig.**35 shows the reduction of the setup time margin T_{MS} caused by the skew T_{SKEW} since the subsequent flip-flop FFⱼ is clocked earlier than the previous one FFᵢ. The hold time margin T_{MH} in this example (see **Fig**.36) is increased. The pulse width T_{CPW} may be adjusted to the requirements of the design or by a loop as shown before.

**List of reference signs:**

| | |
|---|---|
| **1** | edge-triggered buffer flip-flop of a first type |
| **2** | edge-triggered buffer flip-flop of a second type |
| **3** | double-edge triggered buffer flip-flop (third type) |
| **30** | multiplexer |
| **4** | inverter |
| **4'** | gate diffusion technique based pmos-nmos device |
| **40** | buffer, delay causing element |
| **5** | clocked inverter, |
| **5'** | clocked inverter in a feedback loop |
| **6** | pmos transistor |
| **7** | nmos transistor |
| **8** | transmission gate (TGate) |
| **9** | AND gate |
| **10** | NOR gate |
| **11** | Or gate |
| **12** | NAND gate |
| **13** | AND-NOR gate |
| **14** | OR-NAND gate |
| **15** | D-flip-flop in toggle configuration with asynchronous clear |
| **16,17,18,19,20,21** | clock distributionblocks (brancj with clock skewing) |
| **22** | edge-triggered buffer flip-flop of the first type with buffered clock forwarding |
| **23** | combinational logic |
| **24** | leading edge signal outputs (with skewing) |
| **25** | inverted edge signal outputs |
| **26** | additional delay block (optional) |
| **27** | edge-triggered buffer flip-flop with Scan input and Scan enable. |
| **100** | double edge (dual edge) triggered D-flip-flop |
| DI | Input Data |
| DO | Output Data |
| D̅O̅ | inverted Output Data |
| CLK, CLKN | Clock input signal |
| CLK₁ | Clock output signal |
| DCLK, DCLKN | delayed Clock signal input |
| CT | internal content |
| 1D | Data input |
| C1,C1N | Clock signal input for Data input |
| CCT, CCTN | Clock signal for internal content to Data output |
| C2, Cn3 | complementary Clock inputs |
| 3CT | Data Output |
| 3C̅T̅ | inverted Data Output |
| G1 | Selection input |
| A | skewing block input |
| B | skewing block output |

## Claims

1. Synchronous sequential logic device with a combinational logic circuit and state storing registers **comprising** a plurality of modified first, second or third types of flip-flops (1,2 or 3) wherein each flip-flop has a different point in time for the acceptance of a new data value (DI) at its Data Input (1 D) compared to the point in time for the release of the data value to its Data Output (DO), keeping a frozen content state (CT) between these points in time,
and wherein these points in time are defined by different edges (CLK,DCLKN or CLKN,DCLK) at two separate clock inputs (C1,CCTN or C1N,CCT), preferably by consecutively edges of one single clock signal CLK at both clock inputs (C1N=CCT or C1=CCTN),
in particular the first type (1) of a modified flip-flop accepts data at the data input (1 D) at the positive edge of a signal at the first clock input (C1) and releases the content value to the output (DO) or inverted to another output at the negative edge of a signal at the second clock input (CCTN),
and conversely the second type (2) accepts data at the negative edge of a signal at the first clock input (C1 N) and releases the data at the positive edge at the second clock input (CCT),
and combined the third type (3) accepts data at both edges of a signal at the first clock input (C1) and releases the buffered content at the subsequent positive or negative edge at the second clock input (CCT).

2. Device of claim 1 **wherein** the flip-flops (1,2,3) comprise a second input for scan purpose and an input selector especially a multiplexer.

3. Device of claim 1 **wherein** each third type (3) of a modified flip-flop comprises one flip-flop of the first type (1) and one modified flip-flop of the second type (2) whereby both data inputs are connected together (1 D), the data accepting clock-inputs (C1 and C1N) and the content releasing clock-inputs (CCTN and CCT) are shorted and wherein the outputs are multiplexed with the help of a multiplexer (30) whose inputs are selected by the content clocking signal (DCLK).

4. Device of one of the claims 1 to 3 **wherein** each flip-flop (1,2,3) comprises three latches in a two stages master-slave configuration resulting in a master slave-subslave configuration.

5. Device of claim 4 **wherein** at least one latch is a modified clocked complementary metal oxide semiconductor circuit mC²MOS, constructed by a clocked inverter (5) and a feedback loop with an inverter (4) and either a further clocked inverter (5') or a transmission gate.

6. Device of claim 4 **wherein** at least one latch is constructed by a clocked transmission gate (8), and a feedback loop with an inverter (4) and either a clocked inverter (5), to represent an extended PowerPC-latch or a second clocked transmission gate, to represent an extended Transmission-Gate based latch.

7. Device of claim 4 **wherein** the master and the sub-slave are AND-NOR-latches and the slave is an OR-NAND-latch or vice versa the master and the sub-slave are OR-NAND-latches and the slave is an AND-NOR-latch.

8. Device of claim 4 **wherein** each latch is constructed in Gate-Diffusion-Input-technique and comprises two gate clocked pmos - nmos (4') serial circuits connected to two complementary data inputs (D,D̅) and two inverters for inverting the outputs of the pmos devices to the third connection of the nmos devices of the other branch.

9. Device of claim 4 **wherein** each flip-flop (1,2,3) comprises a clocked sense amplifier stage with differential inputs and differential outputs as a latch.

10. Device of claim 4 **comprising** three latches of at least two different types - serially combined to a flip-flop - with two separated edge trigger points in time for acceptance of the input-data and release of the internal stored value to the output.

11. Device of one of the claims 1 to 10 **comprising** a number of n modified flip-flops of first, second or third type (1,2,3) are serially clocked in time due to skew caused by serially connecting inverter or buffer chains (16-21) either contained in the flip-flops or in parallel to the flip-flops.

12. Device of claim 11 **comprising** a pulse generator that is triggered by the rising or falling edge of a system clock signal and that pulse generator generates skewed first edge signals for the acceptance points in time along all n modified flip-flops and wherein the last signal change asynchronously terminates the pulse duration to generate a skewed second edge signal for the release points in time in the same order along all n modified flip-flops.

13. Device of claim 12 **comprising** two pulse generators and two branches of modified flip-flops wherein one pulse generator is triggered by the rising edge and the other is triggered at the falling edge of a system clock.

14. Device of claim 12 or 13 **comprising** two parallel branches of serially clocked modified flip-flops connected to one pulse-generator where one branch comprises a number of n modified flip-flops and the other comprises a number of m modified flip-flops and wherein the slowest clock first edge transit through the branches (16,18,20) or (17,19,21) determines the asynchronous start of the second edge transit through the branches.

15. Method for triggering a plurality of state storing registers within a sequential synchronous logic device wherein the registers have separated controlling means for acceptance and release of data **comprising** the steps
a. generation of a first edge of a clock pulse synchronous to the system clock;
b. sequentially shifting of this first edge in time with skew producing devices to spread the points in time for acquisition of input data from an interface or a combinational circuit among the clock inputs for acceptance of the registers;
c. using the last edge of the first sequentially time shifted edges to finalize the duration of the clock pulse and to generate a second edge;
d. sequentially shifting the second edge in time with skew producing devices to spread the points in time among the clock inputs for release of the previously stored input data values of each register at their outputs.

16. Method of claim 15 **wherein** the first and the second edge are the transitions of the logical states of a single signal whose state is either changed by the system clock or the last transition point in time of the shifted edges and wherein the separated controlling means are clocked by this single signal respectively its retarded derivatives.

## Patentansprüche

1. Synchrone sequentielle Logikvorrichtung mit doppelflankengesteuerten Flip-Flops und Verharren zur asymmetrischen Ladung von zustandsspeichernden Registern, die verschiedenartige erste, zweite oder dritte Typen von Flip-Flops (1, 2 oder 3) umfasst, wobei jedes Flip-Flop eine andere Taktreaktion auf neue Werte der Eingangssignale (DI) auf seinem Dateneingang (1 D) im Vergleich zur Taktflanke für die Freischaltung von Datenwerten zum dessen Datenausgang hat, indem der inhaltliche Zustand zwischen diesen zwei Taktflanken unverändert bleibt,
diese Takte sind mit verschiedenen Flanken (CLK, DCLKN oder CLKN, DCLK) auf zwei getrennten Taktflankeneingängen (C1, CCTN oder C1N, CCT) definiert, nach Möglichkeit mit sukzessiven Flanken eines einzelnen Taktsignals CLK auf beiden Taktflankeneingängen (C1 N=CCT oder C1=CCTN),
insbesondere übernimmt der erste Typ (1) des geänderten Flip-Flops die Daten auf dem Dateneingang (D1) mit steigender Taktflanke beim ersten Taktsignal (C1) und schaltet den Wert des Inhalts zum Datenausgang (DO) frei oder ist invertiert zum zweiten Ausgang mit fallender Taktflanke beim zweiten Taktsignal (CCTN),
wie auch umgekehrt, der zweite Typ (2) übernimmt die Daten mit fallender Taktflanke beim ersten Taktsignal (C1N) und schaltet Daten auf der steigender Taktflanke beim zweiten Taktsignal (CCT) frei,
und auch in der Kombination, der dritte Typ (3) übernimmt die Daten mit beiden Taktflanken beim ersten Taktsignal (C1) und schaltet den gespeicherten Wert der danach folgenden steigernden oder fallenden Taktflanke beim zweiten Taktsignal (CCT).

2. Die Vorrichtung aus dem 1. Anspruch, bei welcher Flip-Flops (1, 2, 3) einen zweiten Eingang für das Scannen (Datenabtasten) und einen Eingangsselektor, insbesondere einen Multiplexer, haben.

3. Die Vorrichtung aus dem 1. Anspruch, bei welcher der dritte Typ (3) des geänderten Flip-Flops ein Flip-Flop des ersten Typs (1) und ein geändertes Flip-Flop des zweiten Typs (2) hat, wobei beide Dateneingänge verbunden sind (1 D), die Takteingänge für Datenübernahme (C1 und C1 N) wie auch die Takteingänge für die Freischaltung des Inhalts (CCTN und CCT) sind gekürzt und Eingänge durch Multiplexer (30) multiplexiert sind, dessen Eingänge mit Bezug auf den Inhalt des Synchronisationssignals (DCLK) gewählt sind.

4. Die Vorrichtung aus den Ansprüchen 1 bis 3, bei welcher jedes Flip-Flop (1, 2, 3) mit drei Latchs in Zweistufenkonfiguration Master-Slave versehen ist, die die Konfiguration Master-Slave-Subslave zur Folge hat.

5. Die Vorrichtung aus dem 4. Anspruch, bei welcher mindestens ein Latch die geänderte zusätzliche Metal-Oxid - Halbleiterschaltung mC²MOS ist, besteht aus einem synchronen Inverter (5) und einer Rückkopplungsschleife mit Inverter (4) wie auch entweder einem synchronen Inverter (5') oder einem Übertragungsausgang.

6. Die Vorrichtung aus dem 4. Anspruch besteht aus mindestens einem Latch und synchronem Übertragungsausgang (8) und einer Rückkopplungsschleife mit Inverter (4) wie auch entweder noch einem synchronen Takt-Inverter (5'), der den erweiterten PowerPC-Latch darstellt oder einem zweiten Takt-Übertragungsausgang der das erweiterte Latch darstellt, der auf dem erweiterten Übertragungsausgang beruht.

7. Die Vorrichtung aus dem 4. Anspruch, bei welcher Master und Subslave die Latchs AND-NOR sind, Slave jedoch ds Latch OR-NAND ist oder umgekehrt Master und Subslave sind die Latchs OR-NAND, indem Slave das Latch AND-NOR ist.

8. Die Vorrichtung aus dem 4. Anspruch, bei welcher jedes Latch in der Difusion-Eingang-Technik hergestellt ist, besteht aus zwei synchronen sequentiellenTaktausgangsschaltungen pmos - nmos (4'), die mit zwei zusätzlichen Dateneingängen (D, D) verkoppelt sind wie auch aus zwei Inverter zum Invertieren von Ausgängen der pmos-Vorrichtungen auf den dritten Anschluss der nmos-Vorrichtungen des zweiten Zweige.

9. Die Vorrichtung aus dem 4. Anspruch, bei welcher jedes Flip-Flop (1, 2, 3) aus einer synchronen Leseverstärkerstufe mit Ausgleichseingängen und Ausgleichausgängen als ein Latch, besteht.

10. Die Vorrichtung aus dem 4. Anspruch besteht aus drei Latchs von mindestens zwei verschiedenen - als das Flip-Flop hintereinander verbunden - taktflankengetriggerten Typen für die rechtzeitige Übernahme von Eingangsdaten und für die Freischaltung des innerlich gespeicherten Wertes zum Ausgang.

11. Die Vorrichtung aus einem der Ansprüche 1 bis 10, die die n-Anzahl von geänderten Flip-Flops des ersten, zweiten und dritten Typs (1, 2, 3) sind wegen der Verzögerung sequentiell synchronisiert, die aus der hintereinander verbundenen Invertern oder Pufferketten (16-21) resultiert, die sich entweder in den Flip-Flops befinden oder die zu den Flip-Flops parallel sind.

12. Die Vorrichtung aus dem 11. Anspruch, enthält einen Impulsgenerator, der durch die steigernde oder fallende Taktflanke der Systemuhr frei geschaltet wird und welcher verzögerte Signale der ersten Flanke für die Übernahmepunkte alle n-geänderten Flip-Flops entlang produziert. Bei beiden schließt die Änderung des letzten Signals asynchron die Impulsdauer ab wodurch das verzögerte Signal der zweiten Flanke für die Freischaltungspunkte in gleicher Reihenfolge bei allen n-geänderten Flip-Flops frei geschaltet wird.

13. Die Vorrichtung aus dem 12. Anspruch, besteht aus zwei Impulsgeneratoren und zwei Zweigen der geänderten Flip-Flops, wobei ein Impulsgenerator durch die steigernde Flanke und der zweite durch die fallende Flanke der Systemuhr frei geschaltet wird.

14. Die Vorrichtung aus dem 12. oder 13. Anspruch, die aus zwei parallelen Zweigen der synchronen sequentiellen geänderten Flip-Flops besteht, die an einen Impulsgenerator angeschlossen sind, wobei ein Zweig eine bestimmte Anzahl von n-geänderten Flip-Flops und der zweite eine bestimmte Anzahl von m-geänderten Flip-Flops darstellt und bei welchen die langsamste Übertragung der ersten Taktflanke durch die Zweige (16, 18, 20) oder (17, 19, 21) den asynchronen Start der Übertragung der zweiten Taktflanke durch die Zweige darstellt.

15. Die Art der Freischaltung von zustandsspeichernden Registern in der synchronen sequentiellen Logikvorrichtung, bei welcher Register getrennte Mittel für die Steuerung der Übernahme und des Freischaltens von Daten haben, umfasst:
a. Herstellung der ersten Taktflanke, die mit der Systemuhr synchronisiert ist;
b. sequentielle Zeitverschiebung der ersten Flanke anhand von Verzögerungsvorrichtungen damit die Taktpunkte für die Übernahme der Eingangsdaten vom Puffer oder der Kombinationsschaltung zwischen Takteingängen für die Übernahme von Registern erweitert werden können;
c. Verwendung der letzten Taktflanke der ersten sequentiell verzögerten Taktflanken damit die Dauer der Taktflanke abgeschlossen wird und damit die zweite Taktflanke gebildet werden kann;
d. sequentielle Verzögerung der zweiten Taktflanke anhand von Verzögerungsvorrichtungen damit Taktpunkte in die Takteingänge verbreitet werden können und die vorher gespeicherten Werte der Eingangsdaten eines jeden Registers auf ihren Ausgängen frei geschaltet werden können.

16. Die Methode des 15. Anspruchs, bei welchem die erste und die zweite Taktflanke die Übertragung des logischen Zustands eines einzelnen Signals darstellen, deren Zustand entweder durch die Systemuhr oder durch die letzte vorherige verzögerte Taktflanke geändert wurde und bei welcher dieses einfache Signal beziehungsweise ihre verzögerten ausgeführten Formen die getrennten Steuerungsmittel synchronisieren.

## Revendications

1. Dispositif logique séquentiel synchrone utilisant des bascules à double déclenchement et procédés de déclenchement désaligné de ces registres de stockage d'état **comprenant** plusieurs bascules de premier, de second ou de troisième type modifié (1, 2 ou 3), où chaque bascule est munie d'un autre point de temps pour l'acceptation d'une nouvelle valeur de données (DI) à l'entrée de donnée (1 D) comparé au point de temps pour le relâchement de la valeur de données sur sa sortie de données (DO), où l'état du contenu (CT) entre ces deux points de temps reste inchangé,
et ù ces points de temps sont déterminés par les différents bords (CLK,DCLKN ou CLKN,DCLK) sur deux entrées d'horloge séparées (C1,CCTN ou C1N,CCT), de préférence par les bords consécutifs d'un seul signal d'une seule horloge CLK sur les deux entrées de l'horloge (C1N=CCT ou C1=CCTN),
en particulier le premier type (1) de la bascule modifiée accepte les données à l'entrée de données (D1) sur le bord positif du signal à la première entrée de l'horloge (C1) et relâche la valeur du contenu sur la sortie (DO) ou bien il est inverti sur l'autre sortie au bord négatif du signal à la seconde entrée de l'horloge (CCTN),
et réciproquement, le second type (2) accepte les données sur le bord négatif du signal à la première entrée de l'horloge (C1N) et relâche les données sur le bord positif à la seconde entrée de l'horloge (CCT),
et en combinaison, le troisième type (3) accepte les données sur les deux bords du signal à la première entrée de l'horloge (C1) et relâche le contenu du bord subséquent positif ou négatif à la seconde entrée de l'horloge (CCT).

2. Le dispositif de la 1^{ère} revendication, où les bascules (1, 2, 3) comprennent une seconde entrée pour le scanning et un sélecteur d'entrée, en particulier un multiplexeur.

3. Le dispositif de la 1^{ère} revendication, où le troisième (3) type de la bascule modifiée comprend une bascule du premier type (1) et une bascule modifiée du second type (2), où les deux entrées de données sont reliées (1 D), les deux entrées de l'horloge pour l'acceptation des données (C1 et C1N) et les entrées de l'horloge pour le relâchement du contenu (CCTN et CCT) sont court-circuitées et où les entrées sont multiplexées à l'aide du multiplexeur (30), dont les entrées sont sélectionnés suivant le contenu du signal de synchronisation (DCLK).

4. Le dispositif des revendications de 1 à 3, où chaque bascule (1, 2, 3) comprend trois verrous en configuration maître-esclave, dont le résultat est la configuration maître-esclave-sousesclave.

5. Le dispositif de la 4^{e} revendication, où au moins un verrou est le circuit semi-conducteur modifié complémentaire en métal oxyde mC²MOS, construit de l'inverseur synchronisé (5) et de la boucle de rétroaction avec l'inverseur (4) ainsi que soit d'un autre l'inverseur synchronisé (5') ou d'une porte de transmission.

6. Le dispositif de la 4^{e} revendication, où au moins un verrou est construit d'une porte synchronisée destinée à la transmission (8) et d'une boucle de rétroaction avec l'inverseur (4) ainsi que soit d'un autre l'inverseur synchronisé (5) ou d'une porte de transmission, représentant un verrou PowerPC étendu, ou d'une autre porte de transmission représentant un verrou étendu, basé sur la porte de transmission.

7. Le dispositif de la 4^{e} revendication, où le maître et le sousesclave sont les verrous AND-NOR, tandis que l'esclave est le verrou OR-NAND ou vice-versa, le maître et le sousesclave sont les verrous OR-NAND, tandis que l'esclave est le verrou AND-NOR.

8. Le dispositif de la 4^{e} revendication, où chaque verrou est construit en technique porte-diffusion-entrée et comprend deux circuits synchronisés en série avec la porte pmos - nmos (4'), connectés à deux entrées de données complémentaires (D, D), ainsi que deux inverseurs pour l'inversion des sorties des dispositifs pmos à la troisième connexion des dispositifs nmos de l'autre branche.

9. Le dispositif de la 4^{e} revendication, où chaque bascule (1, 2, 3) comprend un degré de l'amplificateur synchronisé avec les entrées différentielles et les sorties différentielles en fonction du verrou.

10. Le dispositif de la 4^{e} revendication, comprenant trois verrous d'au moins deux types différents - connectés en série au bascule - avec deux points de déclenchement séparés, destinés à l'acceptation des données d'entrée et au relâchement de la valeur stockée sur la sortie.

11. Le dispositif de l'une des revendications de 1 à 10, comprenant un certain nombre de bascules modifiées en "n" du premier, deuxième et troisième type (1, 2, 3), synchronisées en série à cause du décalage, causé par les chaines des inverseurs ou tampons (16-21) connectées en série, contenues soit dans les bascules ou en parallèle avec les bascules.

12. Le dispositif de la 11^{e} revendication, comprenant le générateur d'impulsions déclenché par le bord ascendant et descendant du signal de l'horloge et ce générateur d'impulsions produit ensuite les signaux décalés du premier bord pour les points d'acceptation le long de toutes les bascules modifiées "n" et dans lesquelles la modification du dernier signal termine la durée de l'impulsion de manière asynchrone et cause un signal décalé du second bord en vue du relâchement des points de temps dans le même ordre le long de toutes les bascules modifiées "n".

13. Le dispositif de la 12^{e} revendication, comprenant deux générateurs d'impulsions et deux branches des bascules modifiées où un générateur d'impulsions est déclenché par le bord ascendant et l'autre par le bord descendant de l'horloge.

14. Le dispositif de la 12^{e} ou 13^{e} revendication, comprenant deux branches parallèles des bascules modifiées synchronisés en série, raccordés sur un générateur d'impulsions où une branche comprend un certain nombre de bascules modifiées "n" et l'autre un certain nombre de bascules modifiées "m" et où le passage le plus lent du premier bord à travers les branches (16, 18, 20) ou (17, 19, 21) détermine le début asynchrone du second bord à travers les branches.

15. Le mode de déclenchement des registres destinés au stockage de la pluralité des états dans le dispositif synchrone à logique séquentielle où les registres sont munis des moyens de commande séparée pour l'acceptation et le relâchement des données qui comprend les pas ci-après
a. génération du premier bord de l'impulsion d'horloge qui est synchronisé avec l'horloge du système;
b. décalage séquentiel du premier bord par les dispositifs qui causent le décalage en vue de distribuer les points de temps pour l'acceptation des données d'entrée de l'interface ou du circuit combinatoire entre les entrées de l'horloge pour l'acceptation des registres;
c. utilisation du dernier bord des premiers bords décalés en série en vue de terminer la durée de l'impulsion d'horloge et de générer un second bord;
d. décalage séquentiel du second bord par les dispositifs qui causent le décalage en vue de distribuer les points de temps entre les entrées d'horloge en vue du relâchement des valeurs des données d'entrée stockées précédemment du chaque registre à leurs sorties;

16. Le mode de la 15^{e} revendication, où le premier et le second bord sont les transitions des états logiques d'un seul signal dont l'état est soit changé à l'aide de l'horloge de système ou bien à l'aide du dernier point de temps de transition des bords décalés et où les moyens de commande séparée sont synchronisés par ce signal unitaire ou bien par ses formes dérivées retardées.
